# EUROPEAN PATENT SPECIFICATION

(11) **EP 3 894 417 B1**
(45) Date of publication and mention of the grant of the patent: **07.12.2022**
(21) Application number: 19828605.6
(22) Date of filing: 11.12.2019
(51) Int. Cl.: C07F 5/00, H01B 1/12, H01G 9/20, H01M 10/00, H01L 51/00, H01M 4/525, H01M 10/0525, H01M 10/0567, H01M 10/0568, H01M 4/587

(54) **NOVEL GALLIUM COMPOUNDS AND THEIR USE**
NEUARTIGE GALLIUMVERBINDUNGEN UND DEREN VERWENDUNG
NOUVEAUX COMPOSÉS DE GALLIUM ET LEUR UTILISATION

(30) Priority: 13.12.2018 DE 102018132156
(43) Date of publication of application: 20.10.2021
(73) Proprietor: Universität Bielefeld, 33615 Bielefeld (DE)
(72) Inventor: HOGE, Berthold, 33604 Bielefeld (DE); NIEMANN, Mark, 32425 Minden (DE); PORATH, Sven, 33613 Bielefeld (DE)
(74) Representative: Michalski Hüttermann & Partner Patentanwälte mbB
(86) International application number: PCT/EP2019/084720
(87) International publication number: WO 2020/120609

(56) References cited:
- US-A- 4 594 264
- US-A1- 2014 162 141
- Mark Niemann: "Pentafluoroethylgallium compounds - Syntheses, Properties and Application", Doctoral thesis, 1 January 2018 (2018-01-01), page 1, XP055661498, Universität Bielefeld Retrieved from the Internet: URL:https://www.uni-bielefeld.de/chemie/ac ii/hoge/EN/mark.html [retrieved on 2020-01-24]
- GUERRA M A ET AL: "Synthesis of tris(trifluoromethyl)gallium and its adducts", JOURNAL OF ORGANOMETALLIC CHEMISTRY, ELSEVIER, AMSTERDAM, NL, vol. 390, no. 3, 10 July 1990 (1990-07-10) , pages c73-c76, XP027222828, ISSN: 0022-328X [retrieved on 1990-07-10]
- Dieter Naumann ET AL: "Polar trifluoromethylation reactions: syntheses of trifluoromethyl gallium, indium, and thallium compounds. The mechanism of polar trifluoromethyl group transfer *", Journal of Organometallic Chemistry, 1 January 1991 (1991-01-01), pages 1-15, XP055661495, Retrieved from the Internet: URL:https://www.sciencedirect.com/science/ article/pii/0022328X9183135Q?via%3Dihub [retrieved on 2020-01-24]
- Mark Niemann: "Pentafluorethylgallium-Verbindungen Synthesen,Eigenschaften und Anwendungen", UB Bielefeld , May 2019 (2019-05), Retrieved from the Internet: URL:https://katalogplus.ub.uni-bielefeld.d e/Record/991000022369706442

## Description

The present invention relates to the field of gallium-containing compounds and their use e.g. in batteries or as ionic liquids in Lewis acids and photoacid generators or the like. Compounds which are able to be used in these applications and related applications are highly sought after and there is a constant need for alternative and possibly even improved compounds, which is therefore an object of the present invention.

Gallium compounds are inter alia known from: GUERRA M A ET AL: "Sythesis of tris(trifluoromethyl)gallium and its adducts", JOURNAL OF ORGANOMETALLIC CHEMISTRY, ELSEVIER, AMSTERDAM, NL, vol. 390, no. 3, 10 July 1990, pages c73-c76; Dieter Naumann ET AL: "Polar trifluoromethylation reactions: syntheses of trifluoromethyl gallium, indium, and thallium compounds. The mechanism of polar trifluoromethyl group transfer", Journal of Organometallic Chemistry, 1 January 1991, pages 1-15; and US 4,594,264. US 2014/162141 A1 discloses LiGa(CN)4 for use in a positive electrode for an all-solid battery.

This object is solved by Claim 1 of the present invention which provides a gallium-containing compound comprising the moiety:

GaR¹R²R³R⁴

whereby
R¹ is a fluoroalkyl, fluoroalkenyl and/or fluoroalkynyl moiety of the structure CₘHₙFₒ, whereby m>1, n≥0 and o>0, whereby in one or more C-C bonds (if they are present) a -O-, - S-, -NH-, -CO-, -COO-, -OCO-, -OCO-O-, -SO₂-, -S-CO-, -CO-S- unit may be inserted in that way that O and/or S atoms are not directly bound to each other.
R² to R⁴ are independently from each other a moiety as defined for R¹, halogen, fluoroaryl, amines, aminocycloalkyl, N-heteroaryl, phosphanides, amide, phosphanes, alkyloxy, ethers, water or a moiety of the structure -R⁵-GaR⁶R⁷R⁸ whereby R⁵ is selected out of the group comprising halogen, O, alkyloxy, amine, phosphanide, R⁶ is defined same as R¹ and R⁷ and R⁸ are defined as a moiety as defined for R¹, halogen, fluoroaryl, amines, aminocycloalkyl, N-heteroaryl, phosphanides, amide, phosphanes, alkyloxy, ethers, water.

Surprisingly, it has been found that compounds of these structure can be widely used for many applications, as will also be described later on. For most applications within the present invention, at least one of the following advantages could be observed:
- The compounds can be synthesized on a large scale using well-known reaction types
- The compounds are usually stable, often also air-stable, and can be handled without the use of sophisticated equipment. Many are even stable in 1 M aqueous LiOH, NaOH or HCl
- The compounds are usually non-toxic
- The compounds have usually a high thermal stability
- Many compounds are liquids within a broad temperature range.
- Many compounds show a high conductivity
- Many compounds are miscible with most common organic solvents

Generic group definition: Throughout the description and claims generic groups have been used. Unless otherwise specified the following are preferred groups that may be applied to generic groups found within compounds disclosed herein:
Halogene: selected from fluorine, chlorine, bromine and iodine, preferably fluorine or chlorine
N-heteroaryl: selected from the group consisting of substituted or unsubstituted pyridinyl; pyrimidinyl; pyrazinyl; triazolyl; pyridazinyl; 1,3,5-triazinyl; quinolinyl; isoquinolinyl; quinoxalinyl; imidazolyl; pyrazolyl; benzimidazolyl; oxazolidinyl; pyrrolyl; carbazolyl; indolyl; and isoindolyl. Especially preferred are alkyl or amino substituted or unsubstituted pyridinyl moieties, more preferred unsubstituted or N-dialkylsubstituted pyridinyl moieties.
aminocycloalkyl: selected from the group consisting of: pyrrolinyl; pyrrolidinyl; morpholinyl; piperidinyl; piperazinyl; hexamethylene imine; 1,4-piperazinyl; 1,4,7- triazacyclononanyl; 1,4,8,11-tetraazacyclotetradecanyl; 1,4,7,10,13- pentaazacyclopentadecanyl; 1,4-diaza-7-thiacyclononanyl; 1,4-diaza-7-oxa- cyclononanyl; 1,4,7,10-tetraazacyclododecanyl
fluoroaryl: selected from the group consisting of: phenyl; biphenyl; naphthalenyl; anthracenyl; and phenanthrenyl, whereby one or more hydrogen atoms are substituted by fluorine. Preferably all hydrogen atoms are substituted by fluorine.
amide: the group -N(R)₂ wherein each R is independently selected from: hydrogen; C₁-C₆-alkyl; C₁-C₆-alkyl-C₆H₅; and phenyl, wherein when both R are C₁-C₆-alkyl both R together may form an - NC₃ to an -NC₅ heterocyclic ring with any remaining alkyl chain forming an alkyl substituent to the heterocyclic ring.
amine: the group -N(R)₃ wherein each R is independently selected from: hydrogen; C₁-C₆-alkyl; C₁-C₆-alkyl-C₆H₅; and phenyl, wherein when both R are C₁-C₆-alkyl both R together may form an - NC₃ to an -NC₅ heterocyclic ring with any remaining alkyl chain forming an alkyl substituent to the heterocyclic ring.
alkoxy: C₁-C₆-alkoxy.
phosphanide: the group -P(R)₂, wherein each R is independently selected from: hydrogen; C₁-C₆-alkyl; phenyl; and C₁-C₆-alkyl-C₆H₅.
phosphane: the group -P(R)₃, wherein each R is independently selected from: hydrogen; C₁-C₆-alkyl; phenyl; and C₁-C₆-alkyl-C₆H₅.

In the following the moiety R¹ will be further described. The same goes, if necessary, *mutatis mutandis* for the moieties R² to R⁴ as well as R⁶ to R⁸.

According to a preferred embodiment of the present invention R¹ is fluoroalkyl. This has been shown to be advantageous for many applications due to the often somewhat higher stability.

According to a preferred embodiment of the present invention, o>n, i.e. there are more fluoro substitutents than hydrogens in R¹.

According to preferred embodiment of the present invention there no hydrogens at the ω-carbon (seen from the Gallium).

According to a preferred embodiment of the present invention, m is ≤ 8, i.e. that the moiety R¹ comprises 8 carbon atoms or less. R¹ may be a straight or branched moiety.

According to a preferred embodiment of the present invention, n is 0, i.e. R¹ is a perfluoro moiety.

According to a preferred embodiment, at least one of R² and R³, preferably both of R² and R³ are a moiety as defined for R¹. More preferred at least one of R² and R³, preferably both are identical with R¹.

The moiety GaR¹R²R³R⁴ according to the present invention may be non-charged or charged, depending whether one of the R² to R⁴ is suitable substituted (e.g. being an amine group).

In case the moiety is non-charged then it is preferred that the compound consists of this moiety, i.e. there are no further moieties present.

In this case it is especially preferred that at least one of R² and R³, preferably both are identical with R¹ and R⁴ is an ether, water, aminocycloalkyl, N-heteroaryl, phosphanides, amide, phosphanes,

In case the moiety is charged, then the compound comprises one or more counter-ions, usually cations as the moiety will usually be negatively charged. It is therefore a preferred embodiment of the present invention that the compound comprises one or more cations.

If the compound is charged then according to a preferred embodiment, at least one of R², R³ and R⁴ are a moiety as defined for R¹. More preferred at least one of R² to R⁴, preferably all of R² to R⁴ are identical with R¹, i.e according to a preferred embodiment of the present invention there are four identical ligands at the gallium.

Preferred cations are selected out of the group comprising NO⁺, H⁺, oxonium cations, metal and organic cations.

Preferred metal cations are preferably cations derived of the groups IA, IB, IIA, IIB, IIIB (including Lanthanides), IVB, VB, VIB, VIIB, VIIB of the Periodic System and Al, Ga, In, Ge, Sn, Pb, Sb, Bi, metallocenium cations like ferrocenium, cobaltocenium, *etc.* Especially preferred are alkali, earth alkali and rare earth cations.

Preferred organic cations are selected out of the group ammonium, phosphonium, sulfonium, guanidinium, uronium, thiouronum, iodonium, carbenium ions, especially topylium and tritylium and heterocyclic cations, preferably as defined and described in the US 2012/0309982

It should be noted that depending on the application and also the chosen synthesis method, there may be further ligands present in the inventive compound (such as diethyl carbonate etc.).

The present invention furthermore relates to use of the inventive compound in batteries, as well as to a battery, comprising an inventive compound.

In this case the compound is preferably charged and furthermore preferably comprises at least one or more cations selected out of alkali and earth alkali, more preferred lithium and/or magnesium.

The present invention furthermore relates to use of the inventive compound as ionic liquid, as well as to an ionic liquid, comprising an inventive compound.

In this case the compound is preferably charged and furthermore preferably comprises at least one or more organic cations. Especially preferred cations are ammonium, phosphonium, guanidinium carbenium ions, especially topylium and tritylium, oxonium and heterocyclic cations.

Non-limiting examples of inventive compounds which can be used as ionic liquids according to the present invention e.g. include [Li(dec)₂][Ga(C₂F₅)₄], [H(OEt₂)₂][Ga(C₂F₅)₃Cl] or [{OH₃(OH₂)₂ₕ][Ga(C₂F₅)₄]₂ the synthesis of which is described later on.

The present invention furthermore relates to use of the inventive compound as photopolymerization initiator and/or photoacid generator, as well as to a photopolymerization initiator and/or photoacid generator, comprising an inventive compound.

In this case the compound is preferably charged and furthermore preferably comprises at least one or more organic cations

In this case the compound is preferably charged and furthermore preferably comprises at least one or more organic cations. Especially preferred cations are ammonium, phosphonium, guanidinium carbenium ions, especially topylium and tritylium, oxonium and heterocyclic cations.

The present invention furthermore relates to use of the inventive compound as antistatic agent, as well as to an antistatic agent, comprising an inventive compound.

The present invention furthermore relates to use of the inventive compound as (Lewis-)acid catalysts, as well as to a (Lewis-)acid catalyst, comprising an inventive compound.

In this case the compound is preferably non-charged.

The present invention furthermore relates to use of the inventive compound as conductive salt in cyclovoltametry, as well as to as conductive salt in cyclovoltametry, comprising an inventive compound.

The present invention furthermore relates to use of the inventive compound as stabilizer of catalysts in polymerisations reactions, as well as to a stabilizer of catalysts in polymerisations reactions, comprising an inventive compound.

The present invention furthermore relates to a synthesis method of the inventive compounds comprising the step of
a) contacting a gallium halogenide with a compound M-R¹ or Si(R¹)(R)₃ where R¹ is as defined above, R is an organic moiety and M is a metal, preferably selected out of Li and/or Mg or a Trialkylsilyl moiety, preferably Trimethylsilyl

Surprisingly it has been shown that by doing so the inventive compound can be obtained with good yields.

The gallium halogenide is preferably GaCl₃. The compound M-R¹ is preferably prepared *in situ.*

In case that the other moieties R² to R⁴ are bound to the gallium in the inventive compound via a gallium-carbon bond, then preferably the method comprises the step;
b) contacting the galliumhalogenide with a compound M-R^{x} or Si(R^{x})(R)₃ where x is 2, 3 or 4 and M is as described above.

It goes without saying the steps a) and b) can be done simultaneously (especially when any of the R² to R⁴ are identical with R¹) or stepwise. Of course step b) can be repeated to introduce more than one moiety R^{x}.

In case that one or more of the moieties R² to R⁴ have a free electron pair (e.g. they are amines or N-heterocyclic), then preferably the method comprises a step of:
c) contacting the gallium halogenide with the moiety R^{x} where x is 2, 3 or 4.

Step c) can - depending on the application - be performed before step a) (and possibly step b) or afterwards.

Steps a) to c) are preferably performed in a dipolar aprotic solvent, whereby ethers, either linear or cyclic, are preferred.

Preferably steps a) to c) are performed in a protective gas atmosphere and at a temperature of ≥ - 100 °C to ≤ -50 °C.

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the sub-claims and the following description of the respective figures and examples -which in an exemplary fashion--show preferred embodiments according to the invention. Such embodiments do not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.
Fig. 1 shows a voltage and current profile of the initial cycles of a cell using the inventive compound; and
Fig. 2 shows a voltage and current profile of the initial cycles of a cell using a reference compound.

### Examples:

In the following the synthesis of several inventive compounds is disclosed. Again, it is to be understood that both the foregoing general description and the following detailed description are exemplary and explanatory only and are intended to provide further explanation of the present invention as claimed.

### Synthesis of [PPh₄] [Ga(C₂F₅)₃Cl]

A solution of *n*-butyllithium (122 mL, 195 mmol, 1.6M in *n*-hexane) in diethyl ether (400 mL) was degassed at -80 °C. Pentafluoroethane (1833 mbar, 229 mmol) was condensed onto the solution. After stirring for 30 min at -80 °C a solution of gallium trichloride (8.27 g, 47.0 mmol) in diethyl ether (20 mL) was added to the in situ generated pentafluoroethyllithium at -80 °C and the mixture was allowed to reach room temperature within 5 h. Tetraphenylphosphonium chloride (23.52 g, 62.4 mmol) was added to the crude product suspension and stirred for 4 d. The precipitate was filtered off and all volatile components of the filtrate were removed in high vacuum. Tetraphenylphosphonium chlorotris(pentafluoroethyl)gallate, [PPh₄][Ga(C₂F₅)₃Cl], was obtained as a colorless solid (32.24 g, 40.22 mmol, 85 %). Crystals suitable for XRD were grown from a slowly evaporating chloroform solution.
M.p.: 84 °C.
¹H NMR ([D]chloroform, 298 K): δ= 7.9 (m, 4H; para-CH), 7.8 (m, 8H; meta-CH), 7.7 ppm (m, 8H; ortho-CH);
¹³C{¹H} NMR ([D]chloroform, 298 K): δ= 135.7 (d, ⁴*J*(P,C)=3 Hz; para-CH), 134.3 (d, ³*J*(P,C)=10 Hz; meta-CH), 130.7 (d, ²*J*(P,C)=13 Hz; ortho-CH), 117.5 ppm (d, ¹*J*(P,C)=90 Hz; ipso-C);
¹³C{¹⁹F} NMR ([D]chloroform, 298 K): δ= 125.6 (s (broad); CF₂), 121.2 ppm (s; CF₃);
¹⁹F NMR ([D]chloroform, 298 K): δ= -124.7 (s, ¹*J*(F,C)=286 Hz, 6F; CF₂), -83.1 ppm (s, ¹*J*(F,C)=283 Hz, 9F; CF₃);
³¹P{¹H} NMR ([D]chloroform, 298 K): δ= 23.4 ppm (s, ¹*J*(P,C)=90 Hz, ²*J*(P,C)=13 Hz, ³*J*(P,C)=10 Hz; P);
IR (ATR): *ṽ* = 1577(m), 1485(m), 1438 (m), 1312(m), 1294(m), 1176(w), 1094(m), 1026 (w), 998 (s), 931 (m), 751 (m), 688 (s), 597 (w), 524 (s), 454 (m), 369 cm⁻¹(m);
MS (ESI, pos.) *{m*/*z* (%) [assignment]}: 339.2 (100) [PPh₄]⁺;
MS (ESI, neg.) *{m*/*z* (%) [assignment]}: 361.1 (2) [Ga(C₂F₅)₂ClF]⁻, 443.2 (5) [Ga(C₂F₅)₃(OH)]⁻, 462.7 (100) [Ga(C₂F₅)₃Cl]⁻, 544.7 (1) [Ga(C₂F₅)₄]⁻;
accurate mass (ESI): calcd. for C₆F₁₅GaCl⁻ 460.87103; found 460.8712;
elemental analysis calcd. (%) for C₃₀H₂₀ClF₁₅GaP: C 44.95, H 2.51, Ga 8.70; found: C 44.85, H 2.79, Ga 8.58.

### Synthesis of [PPh₄] [Ga(C₂F₅)₄Cl]

A 500 mL ampoule with a Young valve was charged with metallic gallium (1.426 g, 20.69 mmol) and melted. Slowly, excess chlorine was allowed to stream into the ampoule until no metallic gallium was observed and a white crystalline solid was obtained. After a day under chlorine atmosphere, all volatile compounds were removed in vacuum. Gallium trichloride (3.575 g, 20.57 mmol, 99%) was obtained as a white crystalline solid and used without purification or analysis.

A solution of *n*-butyllithium (53 mL, 85 mmol, 1.6 M in *n*-hexane) in diethyl ether (250 mL) was degassed at -80 °C. Pentafluoroethane (917 mbar, 115 mmol) was condensed onto the solution. After stirring for 30min at -80 °C a solution of gallium trichloride (3.575 g, 20.57 mmol) in diethyl ether (28 mL) was added to the in situ generated pentafluoroethyllithium at -80 °C and the mixture was allowed to reach room temperature within 6.5 h. Tetraphenylphosphonium chloride (11.182 g, 29.89 mmol) was added to the crude product suspension and stirred for 4 d. The precipitate was filtered off and all volatile components of the filtrate were removed in high vacuum. Tetraphenylphosphonium chlorotris(pentafluoroethyl)gallate, [PPh₄][Ga(C₂F₅)₃Cl], was obtained as a colorless solid (15.555 g, 19.44 mmol, 95 %).
M.p.: 89 °C.
¹H NMR ([D]chloroform, 298 K): δ= 7.9 (m, 4H; para-CH), 7.7 (m, 8H; meta-CH), 7.6 ppm (m, 8H; ortho-CH);
¹⁹F NMR ([D]chloroform, 298 K): δ= -124.9 (s, ¹*J*(F,C)=287 Hz, 6F; CF₂), -83.2 ppm (s, ¹*J*(F,C)=283 Hz, 9F; CF₃);
MS (ESI, pos.) *{m*/*z* (%) [assignment]}: 339.2 (100) [PPh₄]⁺;
MS (ESI, neg.) *{m*/*z* (%) [assignment]}: 255.1 (16), 262.7 (28) [Ga(C₂F₅)ClF₂]⁻, 360.8 (28) [Ga(C₂F₅)₂ClF]⁻, 462.7 (100) [Ga(C₂F₅)₃Cl]⁻, 544.7 (1) [Ga(C₂F₅)₄]⁻.

### Synthesis of [PPh₄][Ga(C₂F₅₎₃Br]

Sodium bromide (1.42 g, 13.79 mmol) was added to a colorless solution of [PPh₄][Ga(C₂F₅)₃Cl] (3.38 g, 4.21 mmol) in methanol (35 mL). After stirring the solution for 3 days, a colorless solid precipitated. All volatile components of the suspension were removed in high vacuum. Diethyl ether (40 mL) was added to the colorless residue and the precipitate of the suspension was filtered off. Removal of all volatile components of the clear filtrate in high vacuum afforded tetraphenylphosphonium bromotris(pentafluoroethyl)gallate, [PPh₄][Ga(C₂F₅)₃Br], as a colorless solid (3.294 g, 3.88 mmol, 92%). Based on ¹⁹F NMR spectroscopic data, the product contains 10% [PPh₄][Ga(C₂F₅)₃Cl] as an impurity. Crystals suitable for XRD were grown from a diethyl ether solution at 4°C.
M.p.: 86 °C.
¹H NMR ([D]chloroform, 298 K): δ= 7.9 (m, 4H; para-CH), 7.8 (m, 8H; meta-CH), 7.7 ppm (m, 8H; ortho-CH);
¹³C{¹H} NMR ([D]chloroform, 298 K): δ= 135.7 (d, ⁴*J*(P,C)=3 Hz; para-CH), 134.3 (d, ³*J*(P,C)=10 Hz; meta-CH), 130.7 (d, ²*J*(P,C)=13 Hz; ortho-CH), 117.5 ppm (d, ¹*J*(P,C)=90 Hz; ipso-C);
¹³C{¹⁹F} NMR ([D]chloroform, 298 K): δ= 125.0 (s (broad); CF₂), 121.2 ppm (s; CF₃);
¹⁹F NMR ([D]chloroform, 298 K): δ= -124.0 (s, ¹*J*(F,C)=288 Hz, 6F; CF₂), -82.8 ppm (s, ¹*J*(F,C)=284 Hz, 9F; CF₃);
³¹P{¹H} NMR ([D]chloroform, 298 K): δ= 23.3 ppm (s, ¹*J*(P,C)=90 Hz, ²*J*(P,C)=13 Hz, ³*J*(P,C)=10 Hz; P);
IR (ATR): *ṽ* = 1485 (m), 1438 (m), 1312 (m), 1293 (m), 1177 (w), 1093 (m), 1027 (w), 998 (s), 931 (m), 751 (m), 722 (s), 688 (s), 597 (w), 524 (s), 368 cm⁻¹ (w);
MS (ESI, pos.) *{m*/*z* (%) [assignment]}: 339.2 (100) [PPh₄]⁺;
MS (ESI, neg.) *{m*/*z* (%) [assignment]}: 406.7 (1) [Ga(C₂F₅)₂BrF]⁻, 442.8 (4) [Ga(C₂F₅)₃(OH)]⁻, 462.7 (21) [Ga(C₂F₅)₃Cl]⁻, 506.6 (100) [Ga(C₂F₅)₃Br]⁻, 544.7 (1) [Ga(C₂F₅)₄]⁻;
accurate mass (ESI): calcd. for C₆F₁₅GaBr⁻ 504.807; found 504.82051.

### Synthesis of [PPh₄] [Ga(C₂F₅)₃I]

An excess of sodium iodide (0.927 g, 6.184 mmol) was added to a colorless solution of [PPh₄][Ga(C₂F₅)₃Cl] (0.863 g, 1.078 mmol) in acetone (20 mL). After stirring the suspension for 3 days, the precipitate was filtered off. The solvent was removed, the colorless residue suspended in diethyl ether and the precipitate was filtered off. The solvent was removed, the residue suspended in dichloromethane and the precipitate was filtered off. Removal of all volatile components of the filtrate in high vacuum afforded tetraphenylphosphonium iodotris(pentafluoroethyl)gallate, [PPh₄][Ga(C₂F₅)₃I], as a light yellow oil (0.586 g, 0.657 mmol, 61%). Based on ¹⁹F NMR spectroscopic data, the product contains unknown impurities. From this oil slowly grew crystals suitable for XRD
M.p.: 93 °C.
¹H NMR ([D]chloroform, 298 K): δ= 7.9 (m, 4H; para-CH), 7.8 (m, 8H; meta-CH), 7.7 ppm (m, 8H; ortho-CH);
¹³C{¹H} NMR ([D]chloroform, 298 K): δ= 135.7 (d, ⁴*J*(P,C)=3 Hz; *para*-CH)*,* 134.3 (d, ³*J*(P,C)=10 Hz; *meta*-CH), 130.7 (d, ²*J*(P,C)=13 Hz; *ortho*-CH)*,* 117.5 ppm (d, ¹*J*(P,C)=90 Hz; *ipso-C*);
¹³C{¹⁹F} NMR ([D]chloroform, 298 K): δ= 124.2 (s (broad); CF₂), 121.1 ppm (s; CF₃);
¹⁹F NMR ([D]chloroform, 298 K): δ= -122.8 (s, ¹*J*(F,C)=288 Hz, 6F; CF₂), -82.3 ppm (s, ¹*J*(F,C)=284 Hz, 9F; CF₃);
³¹P{¹H} NMR ([D]chloroform, 298 K): δ= 23.4 ppm (s, ¹*J*(P,C)=90 Hz, ²*J*(P,C)=13 Hz, ³*J*(P,C)=10 Hz; P);
IR (ATR): *ṽ* = 1484 (w), 1438 (w), 1308 (m), 1288 (w), 1172 (s), 1093 (s), 1025 (m), 997 (w), 922 (w), 752 (w), 721 (s), 687 (m), 585 (w), 524 cm⁻¹(s);
MS (ESI, pos.) *{m*/*z* (%) [assignment]}: 339.2 (100) [PPh₄]⁺;
MS (ESI, neg.) *{m*/*z* (%) [assignment]}: 442.9 (10) [Ga(C₂F₅)₃(OH)]⁻, 462.7 (4) [Ga(C₂F₅)₃Cl]⁻, 544.7 (17) [Ga(C₂F₅)₄]⁻, 552.7 (100) [Ga(C₂F₅)₃I]-, 870.7 (9) [(OH){Ga(C₂F₅)₃}₂]⁻;
accurate mass (ESI): calcd. for C₆F₁₅GaI- 552.80665; found 552.8073.

### Synthesis of [PPh₄] [Ga(C₂F₅)₄]

A solution of *n*-butyllithium (13 mL, 21 mmol, 1.6 M in *n*-hexane) in diethyl ether (200 mL) was degassed at -80 °C. Pentafluoroethane (1076 mbar, 27 mmol) was condensed onto the solution. After stirring for 30min at -80 °C a solution of gallium trichloride (0.508 g, 2.89 mmol) and DMAP (0.352 g, 2.881 mmol) in dichloromethane (20 mL) was added to the in situ generated pentafluoroethyllithium at -80 °C. The mixture was allowed to reach room temperature within 7 h.

Aqueous lithium hydroxide solution (0.33 M, 80 mL) was added to the crude product suspension and stirred for 18 hours. The organic layer was separated and the aqueous layer extracted with diethyl ether (200 mL). The combined organic phases were evaporated to half their volume, tetraphenylphosphonium chloride (1.620 g, 4.33 mmol) was added and stirred for 3 days.

Aqueous hydrochloric acid (1 M, 75 mL) was added to the suspension. The aqueous layer was separated and the organic layer was washed with aqueous hydrochloric acid (1 M, 2 x 50 mL). The combined organic layers were dried over magnesium sulfate and all volatile compounds were removed in high vacuum to obtain a brown solid that was recrystallized from chloroform.

Tetraphenylphosphonium tetrakis(pentafluoroethyl)gallate, [PPh₄][Ga(C₂F₅)₄], was obtained as colorless crystals (1.615 g, 1.83 mmol, 63 %).
M.p.: 135 °C.
¹H NMR ([D]chloroform, 298 K): δ= 7.9 (m, 4H; para-CH), 7.8 (m, 8H; meta-CH), 7.7 ppm (m, 8H; ortho-CH);
¹³C{¹H} NMR ([D]chloroform, 298 K): δ= 135.8 (d, ⁴*J*(P,C)=3 Hz; para-CH), 134.2 (d, ³*J*(P,C)=10 Hz; meta-CH), 130.6 (d, ²*J*(P,C)=13 Hz; ortho-CH), 117.4 ppm (d, ¹*J*(P,C)=90 Hz; ipso-C);
¹³C{¹⁹F} NMR ([D]chloroform, 298 K): δ= 121.2 ppm (s; CF₃);
¹⁹F NMR ([D]chloroform, 298 K): δ= -122.4 (s (broad), 8F; CF₂), -83.8 ppm (s, ¹*J*(F,C)=283 Hz, 12F; CF₃);
³¹P{¹H} NMR ([D]chloroform, 298 K): δ= 23.4 ppm (s, ¹*J*(P,C)=90 Hz, ²*J*(P,C)=13 Hz, ³*J*(P,C)=10 Hz; P);
⁷¹Ga NMR ([D]chloroform, 298 K): δ= 180.1 ppm (s (broad), Ga);
^{7l}Ga NMR ([D₃]acetonitrile, 298 K): δ= 180.1 ppm (m, ²*J*(F,Ga)=115 Hz; Ga);
IR (ATR): *ṽ* = 1485 (w), 1438 (w), 1299 (m), 1201 (m), 1173 (s), 1096 (s), 1025 (s), 997 (m), 921 (s), 723 (s), 689 (s), 526 cm⁻¹(s);
MS (ESI, pos.) *{m*/*z* (%) [assignment]}: 339.2 (100) [PPh₄]⁻;
MS (ESI, neg.) *{m*/*z* (%) [assignment]}: 444.9 (1) [Ga(C₂F₅)₃F]⁻, 518.87 (1), 544.7 (100) [Ga(C₂F₅)₄]⁻;
accurate mass (ESI): calcd. for C₈F₂₀Ga⁻ 544.89419; found 544.8950;
elemental analysis calcd. (%) for C₃₂H₂₀F₂₀GaP: C 43.42, H 2.28, Ga 7.88; found: C 43.65, H 2.58, Ga 7.52.

### Synthesis of [PPh₄] [Ga(C₂F₅)₄]

A 500 mL ampoule with a Young valve was charged with metallic gallium (1.228 g, 17.82 mmol) and melted. Slowly, excess chlorine was allowed to stream into the ampoule until no metallic gallium was observed and a white crystalline solid was obtained. After a day under chlorine atmosphere, all volatile compounds were removed in vacuum. Gallium trichloride (3.021 g, 17.38 mmol, 98%) was obtained as a white crystalline solid and used without purification or analysis.

A solution of *n*-butyllithium (77 mL, 123 mmol, 1.6 M in *n*-hexane) in diethyl ether (250 mL) was degassed at -80 °C. Pentafluoroethane (1205 mbar, 151 mmol) was condensed onto the solution. After stirring for 30min at -80 °C a solution of gallium trichloride (3.021 g, 17.38 mmol) and DMAP (2.108 g, 17.27 mmol) in dichloromethane (20 mL) was added to the in situ generated pentafluoroethyllithium at -80 °C. The mixture was allowed to reach room temperature within 16 h.

Aqueous lithium hydroxide solution (1M, 100 mL) was added to the crude product suspension and stirred for one day. The organic layer was separated and the aqueous layer extracted with diethyl ether (3x je 50 mL). The combined organic phases were evaporated to the half their volume, tetraphenylphosphonium chloride (8.452 g, 22.59 mmol) was added and stirred for 2 days.

Aqueous hydrochloric acid (1 M, 50 mL) was added to the suspension. The aqueous layer was separated and the organic layer was washed with aqueous hydrochloric acid (1 M, 3 x 50 mL). The combined organic layers were dried over magnesium sulfate and all volatile compounds were removed in high vacuum to obtain a brown solid that was recrystallized from chloroform.

Tetraphenylphosphonium tetrakis(pentafluoroethyl)gallate, [PPh₄][Ga(C₂F₅)₄], was obtained as colorless crystals (9.332 g, 10.56 mmol, 61 %).
¹H NMR ([D]chloroform, 298 K): δ= 7.9 (m, 4H; para-CH), 7.8 (m, 8H; meta-CH), 7.7 ppm (m, 8H; ortho-CH);
¹⁹F NMR ([D]chloroform, 298 K): δ= -122.4 (s (broad), 8F; CF₂), -83.8 ppm (s, ¹*J*(F,C)=283 Hz, 12F; CF₃);
MS (ESI, pos.) *{m*/*z* (%) [assignment]}: 339.2 (100) [PPh₄]⁺;
MS (ESI, neg.) *{m*/*z* (%) [assignment]}: 245.0 (2) [Ga(C₂F₅)F₃]⁻, 345.1 (44) [Ga(C₂F₅)₂F₂]⁻, 444.9 (100) [Ga(C₂F₅)₃F]⁻, 544.7 (23) [Ga(C₂F₅)₄]⁻.

### Preparation of [PPh₄][Ga(C₂F₅)₄]

A solution of *n*-butyllithium (20 mL, 21 mmol, 1.6 M in *n*-hexane) in tetrahydrofuran (150 mL) was degassed at -80 °C. Pentafluoroethane (1862 mbar, 47 mmol) was condensed onto the solution. After stirring for 35 min at -80 °C a solution of gallium trichloride (1.05 g, 6.05 mmol) in tetrahydrofuran (15 mL) was added to the in situ generated pentafluoroethyllithium at -80 °C. The mixture was allowed to reach room temperature within 7 h.

The reaction mixture was evaporated to half its volume, aqueous sodium hydroxide solution (1M, 30 mL) was added and stirred for 3 days. Diethyl ether (80 mL) was added and the organic layer was separated. The aqueous layer was extracted with diethyl ether (2 x 40 mL). The combined organic phases were dried over magnesium sulfate and all volatile compounds were removed in high vacuum to obtain a brown oil (0.73 g). The residue was dissolved in diethyl ether (20 mL), tetraphenylphosphonium chloride (1.31 g, 3.49 mmol) was added and the suspension was stirred for 2 days. The precipitate was filtered off and the yellow filtrate was evaporated in high vacuum to obtain a yellow oil (0.56 g). From this oil slowly grew crystals suitable for XRD which were also analyzed by NMR spectroscopy and ESI mass spectrometry.
¹H NMR ([D]chloroform, 298 K): δ= 7.9 (m, 4H; para-CH), 7.8 (m, 8H; meta-CH), 7.7 ppm (m, 8H; ortho-CH);
¹⁹F NMR ([D]chloroform, 298 K): δ= -122.4 (s (broad), 8F; CF₂), -83.8 ppm (s, ¹*J*(F,C)=283 Hz, 12F; CF₃);
MS (ESI, pos.) *{m*/*z* (%) [assignment]}: 339.2 (100) [PPh₄]⁺;
MS (ESI, neg.) *{m*/*z* (%) [assignment]}: 173.0 (5), 301.1 (14), 344.9 (17) [Ga(C₂F₅)₂F₂]⁻, 444.9 (50) [Ga(C₂F₅)₃F]⁻, 544.7 (100) [Ga(C₂F₅)₄]⁻.

### Synthesis of [{OH₃(OH₂)₂}₂][Ga(C₂F₅)₄]₂

A solution of *n*-butyllithium (32 mL, 51 mmol, 1.6M in *n*-hexane) in diethyl ether (250 mL) was degassed at -80 °C. Pentafluoroethane (2137 mbar, 53 mmol) was condensed onto the solution. After stirring for 50 min at -80 °C a solution of gallium trichloride (1.176 g, 6.765 mmol) and DMAP (0.860 g, 7.044 mmol) in dichloromethane was added to the in situ generated pentafluoroethyllithium at -80 °C. The mixture was allowed to reach room temperature within 7 h.

Aqueous lithium hydroxide solution (1M, 100 mL) was added to the crude product suspension and stirred for 15 hours. The organic layer was separated and the aqueous layer extracted with diethyl ether (3 x 100 mL). The combined organic phases were evaporated to half their volume, washed with aqueous hydrogen chloride (1 M, 3 x 50 mL) and dried over magnesium sulfate. All volatile compounds were removed in high vacuum to obtain a brown oil.

The residue was suspended in water (30 mL) for 30 minutes and the clear supernatant was separated. The brown residue was again treated with water (10 mL) and the clear supernatant was removed. All volatile compounds of the combined aqueous solution were removed in high vacuum to obtain [{OF[₃(OF[₂)₂}₂][Ga(C₂F₅)₄]₂, as a clear slightly yellow oil (1.149 g, 1.92 mmol, 28 %).

Crystals suitable for XRD were grown by in situ crystallization in a capillary.
M.p.: -38 °C.
¹H NMR ([D₂]dichloromethane, 298 K): δ= 7.80 ppm (s; H);
¹³C{¹⁹F} NMR ([D₂]dichloromethane, 298 K): δ= 120.7 ppm (s; CF₃);
¹⁹F NMR ([D₂]dichloromethane, 298 K): δ= -121.6 (s (broad), 6F; CF₂), -84.2 ppm (s, ¹*J*(F,C)=283 Hz, 9F; CF₃);
^{7l}Ga NMR ([D₂]dichloromethane, 298 K): δ= 180.8 ppm (s (broad); Ga);
IR (ATR): *ṽ* = 3676 (w), 3602 (w), 1761 (w, broad), 1623 (w), 1311 (m), 1175 (s), 1091 (s), 1014 (m), 928 (m), 819 (w), 732 (w), 528 cm⁻¹ (w);
MS (ESI, neg.) *{m*/*z* (%) [assignment]}: 238.9 (5), 277.0 (2), 304.0 (5), 444.9 (2) [Ga(C₂F₅)₃F]⁻, 544.8 (100) [Ga(C₂F₅)₄]⁻;
elemental analysis calcd. (%) for C₁₆H₁₄F₄ₒGa₂O₆: C 15.99, H 1.17, Ga 11.60; found: C 16.47, H 0.98, Ga 11.41.

This compound is a liquid and it has been found that it is usable as ionic liquid in many applicatons.

### Synthesis of [Ga(C₂F₅)₃(OH₂)₂]

A solution of *n*-butyllithium (27 mL, 43 mmol, 1.6 M in *n*-hexane) in diethyl ether (100 mL) was degassed at -80 °C. Pentafluoroethane (2113 mbar, 53 mmol) was condensed onto the solution. After stirring for 30min at -80 °C a solution of gallium trichloride (1.055 g, 5.991 mmol) and DMAP (0.755 g, 6.18 mmol) in dichloromethane (10 ml) was added to the in situ generated pentafluoroethyllithium at -80 °C. The mixture was allowed to reach room temperature within 17.5 h.

Aqueous lithium hydroxide solution (0.4 M, 50 mL) was added to the crude product suspension and stirred for 4.5 hours. The organic layer was separated and the aqueous layer extracted with diethyl ether (3 x 40 mL). The combined organic phases were evaporated to half their volume, aqueous hydrochloric acid (1 M, 80 mL) was added and the mixture was stirred for 3 hours. The aqueous layer was separated, the organic layer was washed with aqueous hydrochloric acid (1 M, 2 x 80 mL). The combined organic layers were dried over magnesium sulfate and all volatile compounds were removed in high vacuum to obtain a brown oil.

The residue was suspended in water (15 mL) for 30 minutes and the clear supernatant was separated. All volatile compounds of the aqueous solution were removed in high vacuum. The residue (1.449 g) was heated up (100 °C) in a bulb-to-bulb distillation in high vacuum. Bis(aqua)tris(pentafluoroethyl)gallium, [Ga(C₂F₅)₃(OH₂)₂], was obtained as a colorless liquid (0.896 g, 1.94 mmol, 32 % based on GaCl₃).

Crystals suitable for XRD were grown by in situ crystallization in a capillary.
M.p.: -10 °C.
¹H NMR ([D₂]dichloromethane, 298 K): δ= 5.08 ppm (d; H₂O);
¹³C{¹⁹F} NMR ([D₂]dichloromethane, 298 K): δ= 123.9 (s (broad); CF₂), 120.3 ppm (s; CF₃); ¹⁹F NMR ([D₂]dichloromethane, 298 K): δ= -125.0 (s, ¹*J*(F,C)=284 Hz, 6F; CF₂), -84.1 ppm (s, ¹*J*(F,C)=283 Hz, 9F; CF₃);
IR (ATR): *ṽ* = 3675 (w), 3619 (w), 2778 (w), 1611 (w), 1320 (m), 1304 (m), 1182 (s), 1105 (s), 1044 (m), 944 (m), 736 (m), 602 (w), 586 cm⁻¹(w);
MS (ESI, neg.) *{m*/*z* (%) [assignment]}: 238.9 (4), 342.9 (2) [Ga(C₂F₅)₂F(OH)]⁻, 443.2 (100) [Ga(C₂F₅)₃(OH)]⁻, 592.7 (4), 870.5 (3) [(F₅C₂)₃Ga(*µ*-OH)Ga(C₂F₅)₃]⁻;
elemental analysis calcd. (%) for C₆H₄F₁₅GaO₂: C 15.57, H 0.87, Ga 15.07; found: C 15.61, H 0.82, Ga 15.04.

### Synthesis of [Ga(C₂F₅)₃(OEt₂)]

A solution of *n*-butyllithium (46 mL, 74 mmol, 1.6 M in *n*-hexane) in diethyl ether (150 mL) was degassed at -80 °C. Pentafluoroethane (3371 mbar, 84 mmol) was condensed onto the solution. After stirring for 30min at -80 °C a solution of gallium trichloride (2.831 g, 16.285 mmol) in diethyl ether (14 mL) was added to the in situ generated pentafluoroethyllithium at -80 °C and the mixture was allowed to reach room temperature within 5 h.

All volatile compounds of the crude product suspension were removed in high vacuum. The residue was heated up (120 °C) in a bulb-to-bulb distillation in high vacuum. 1,1'-oxybis(ethane)-tris(pentafluoroethyl)gallium, [Ga(C₂F₅)₃(OEt₂)], was obtained as a colorless liquid (4.425 g, 8.850 mmol, 54 %).

Crystals suitable for XRD were grown by in situ crystallization in a capillary.
¹H NMR ([D₃]acetonitrile, 298 K): δ= 3.44 (q, ³*J*(H,H)=7 Hz, 4H; CH₂), 1.14 ppm (t, ³*J*(H,H)=7 Hz, 6H; CH₃);
¹³C{¹H} NMR ([D₃]acetonitrile, 298 K): δ= 65.2 (s; CH₂), 14.6 ppm (s; CH₃);
¹³C{¹⁹F} NMR ([D₃]acetonitrile, 298 K): δ= 123.7 (s (broad); CF₂), 121.0 ppm (s; CF₃);
¹⁹F NMR ([D₃]acetonitrile, 298 K): δ= -124.3 (s, ¹*J*(F,C)=288 Hz, 6F; CF₂), -84.0 ppm (s, ¹*J*(F,C)=283 Hz, 9F; CF₃);
IR (ATR): *ṽ* = 2992 (m), 1395 (m), 1317 (m), 1300 (m), 1185 (m), 1103 (w), 1048 (m), 1010 (w), 940 (s), 881 (m), 760 (s), 736 (w), 600 (s), 585 (m), 534 cm-¹(m);
elemental analysis calcd. (%) for C₁₀H₁₀F₁₅GaO: C 23.98, H 2.01, Ga 13.92; found: C 24.33, H 2.41, Ga 13.51.

### Synthesis of [Ga(C₂F₅)₃(dmap)]

A solution of [Ga(C₂F₅)₃(OEt₂)] (2.56 g, 5.12 mmol) in diethyl ether (10 mL) was added to a suspension of DMAP in diethyl ether (15 mL). The solution was stirred for 2 hours and all volatile compounds were removed in high vacuum. The residue was suspended in chloroform, the precipitate was filtered off and the clear light yellow solution was evaporated to half their volume. Cooling to -25°C led to the precipitation of a colorless crystalline solid. All volatile compounds were removed in high vacuum to obtain 4-(dimethylamino)pyridinetris(pentafluoroethyl)gallium, [Ga(C₂F₅)₃(dmap)] (1.913 g, 3.491 mmol, 68 %).

Crystals suitable for XRD were grown from a dichloromethane solution at -25 °C.
M.p.: 96 °C.
¹H NMR ([D]chloroform, 298 K): δ= 8.06 (d, ³*J*(H,H)=7 Hz, 2H; Ar-H), 6.72 (d, ³*J*(H,H)=7 Hz, 2H; Ar-H), 3.21 ppm (s, 6H; CH₃);
¹³C{¹H} NMR ([D]chloroform, 298 K): δ= 156.6 (s; arom. C), 146.3 (s; arom. C), 107.5 ppm (s; arom. C), 39.5 ppm (s; CH₃);
¹³C{¹⁹F} NMR ([D]chloroform, 298 K): δ= 125.2 (s (broad); CF₂), 120.6 ppm (s; CF₃);
¹⁹F NMR ([D]chloroform, 298 K): δ= -122.5 (s, ¹*J*(F,C)=286 Hz, 6F; CF₂), -83.5 ppm (s, ¹*J*(F,C)=283 Hz, 9F; CF₃);
IR (ATR): *ṽ* = 1642 (w), 1627 (w), 1563 (w), 1315 (w), 1297 (w), 1176 (s), 1098 (m), 1087 (m), 1024 (m), 932 (m), 813 (w), 733 (w), 533 (w), 521 cm⁻¹(w);
elemental analysis calcd. (%) for C₁₃H₁₀F₁₅GaN₂: C 28.44, H 1.84, Ga 12.70; found: C 29.31, H 1.98, Ga 12.12.

### Synthesis of [CPh₃][Ga(C₂F₅)₄]

A solution of *n*-butyllithium (74 mL, 118 mmol, 1.6 M in *n*-hexane) in diethyl ether (250 mL) was degassed at -80 °C. Pentafluoroethane (1183 mbar, 149 mmol) was condensed onto the solution. After stirring for 30min at -80 °C a solution of gallium trichloride (2.941 g, 16.919 mmol) and DMAP (2.067 g, 17.132 mmol) in dichloromethane (25 mL) was added to the in situ generated pentafluoroethyllithium at -80 °C. The mixture was allowed to reach room temperature within 7 h.

Aqueous hydrochloric acid (1 M, 100 mL) was added to the crude product suspension and the aqueous layer was separated. The organic layer was washed with aqueous hydrochloric acid (1 M, 2 x 100 mL). Aqueous lithium hydroxide solution (1 M, 100 mL) was added and the mixture was stirred for 19 hours. The organic layer was separated, the aqueous layer extracted with diethyl ether (2 x 20 mL) and all volatile compounds of the organic layers were removed in high vacuum to obtain a brown liquid (8.394 g).

The residue was dissolved in dichloromethane (20 mL), chlorotriphenylmethane (4.683 g, 4.683 mmol) was added and stirred for 4 hours. The precipitate was filtered off and all volatile compounds of the yellow filtrate were removed in high vacuum. The obtained solid (11.481 g) was washed with *n*-hexane (4 x 10 mL) and all volatile compounds were removed in high vacuum. Triphenylmethylium tetrakis(pentafluoroethyl)gallate, [CPh₃][Ga(C₂F₅)₄], was obtained as an orange solid (10.765 g, 13.6 mmol, 80 %)

Crystals suitable for XRD were grown by slow diffusion of *n*-pentane into a dichloromethane solution.
M.p.: 63 °C (decomp).
¹H NMR ([D]chloroform, 298 K): δ= 8.27 (t, ³*J*(H,H)=7 Hz, 3H; para-CH), 7.89 (t, ³*J*(H,H)=7 Hz, 6H; meta-CH), 7.67 ppm (d, ³*J*(H,H)=7 Hz, 3H; ortho-CH);
¹³C{¹H} NMR ([D]chloroform, 298 K): δ= 211.0 (s; C), 143.5 (s; para-CH), 142.5 (s; ortho-CH), 139.8 (s; ipso-C), 130.6 ppm (s; meta-CH);
¹³C{¹⁹F} NMR ([D]chloroform, 298 K): δ= 121.0 ppm (s; CF₃);
¹⁹F NMR ([D]chloroform, 298 K): δ= -122.3 (s (broad), 8F; CF₂), -83.8 ppm (s, ¹*J*(F,C)=284 Hz, 12F; CF₃);
^{7l}Ga NMR ([D]chloroform, 298 K): δ= 180.1 ppm (s (broad), Ga);
IR (ATR): *ṽ* = 1581 (w), 1483 (w), 1451 (m), 1354 (m), 1311 (s), 1292 (s), 1174 (s), 1028 (m), 932 (s), 839 (s), 807 (s), 768 (s), 732 (s), 701 (s), 622 (s), 607 (s), 465 cm⁻¹(s).
MS (ESI, pos.) *{m*/*z* (%) [assignment]}: 215.0 (11), 243.1 (63) [CPh₃]⁺, 301.1 (32), 304.3 (51), 336.3 (13), 365.2 (25), 543.1 (100), 564.1 (17), 585.1 (16);
MS (ESI, neg.) *{m*/*z* (%) [assignment]}: 344.8 (2) [Ga(C₂F₅)₂F₂]⁻, 444.7 (5) [Ga(C₂F₅)₃F]⁻, 544.7 (100) [Ga(C₂F₅)₄]⁻;
elemental analysis calcd. (%) for C₂₇H₁₅F₂₀Ga: C 41.10, H 1.92, Ga 8.84; found: C 43.13, H 2.78, Ga 8.48.

### Synthesis of [Li(dec)₂][Ga(C₂F₅)₄]

A solution of *n*-butyllithium (95 mL, 152 mmol, 1.6 M in *n*-hexane) in diethyl ether (200 mL) was degassed at -80 °C. Pentafluoroethane (1502 mbar, 188 mmol) was condensed onto the solution. After stirring for 30min at -80 °C a solution of gallium trichloride (3.750 g, 21.57 mmol) and DMAP (2.658 g, 21.77 mmol) in dichloromethane (30 mL) was added to the in situ generated pentafluoroethyllithium at -80 °C. The mixture was allowed to reach room temperature within 21 h.

Aqueous hydrochloric acid (1 M, 100 mL) was added to the crude product suspension and the aqueous layer was separated. The organic layer was washed with aqueous hydrochloric acid (1M, 3 x 100 mL) and the organic layer was evaporated to half its volume. An aqueous lithium hydroxide solution (1 M, 100 mL) was added to the crude product solution and stirred for 22 hours. The organic layer was separated and the aqueous layer extracted with diethyl ether (2 x 30 mL). The combined organic phases were washed with water (2 x 40 mL), all volatile compounds were removed in high vacuum over 3 days to obtain a brown liquid (10.496 g).

Water (40 mL) was added to the brown liquid and a brown oil separated. This mixture was filtered over celite and the filter cake was washed with water (30 mL). Again diethyl ether (160 mL) and lithium hydroxide (2.715 g, 113.03 mmol) were added and the mixture was stirred for 16 hours.

The organic layer was separated and washed with aqueous lithium hydroxide (1 M, 2 x 80 mL). The organic layer was concentrated under reduced pressure and the residue was dissolved in diethyl carbonate (40 mL). At 130 °C, half of the solution was distilled off and all volatile compounds of the distillate were removed in high vacuum over 4 days. [Li(dec)₂][Ga(C₂F₅)₄], was obtained as a yellow, highly fluid liquid (12.333 g, 15.650 mmol, 73 %).

Crystals suitable for XRD were grown by in situ crystallization in a capillary.
¹H NMR ([D]chloroform, 298 K): δ= 4.24 (q, ³*J*(H,H)=7 Hz, ¹*J*(H,C)=149 Hz, 8H; CH₂), 1.34 ppm (t, ³*J*(H,H)=7 Hz, ¹*J*(H,C)=149 Hz, 9H; CH₃);
⁷Li{¹H} NMR ([D]chloroform, 298 K): δ= -0.5 ppm (s; Li);
¹³C{¹H} NMR ([D]chloroform, 298 K): δ= 156.5 (s; C), 65.8 (s; CH₂), 13.7 ppm (s; CH₃); ¹³C{¹⁹F} NMR ([D]chloroform, 298 K): δ= 120.8 ppm (s; CF₃);
¹⁹F NMR ([D]chloroform, 298 K): δ= -122.3 (s, 8F; CF₂), -83.9 ppm (s, ¹*J*(F,C)=283 Hz, 12F; CF₃);
^{7l}Ga NMR ([D]chloroform, 298 K): δ= 175.4 ppm (s (broad), Ga);
IR (ATR): *ν̃* = 2993 (w), 1704 (m), 1663 (w), 1485 (w), 1420 (w), 1383 (m), 1308 (s), 1178 (s), 1093 (s), 1021 (m), 932 (s), 848 (w), 795 (w), 773 (m), 585 cm⁻¹(w);
MS (ESI, neg.) *{m*/*z* (%) [assignment]}: 144.7 (9) [GaF₄]⁻, 244.7 (10) [Ga(C₂F₅)F₃]⁻, 344.8 (3) [Ga(C₂F₅)₂F₂]⁻, 444.8 (1) [Ga(C₂F₅)₃F]⁻, 544.8 (100) [Ga(C₂F₅)₄]⁻;
elemental analysis calcd. (%) for C₁₈H₂₀F₂₀GaLiO₆: C 27.40, H 2.56, Ga 8.75, Li 0.88; found: C 27.62, H 2.69, Ga 8.75, Li 0.85.

### Synthesis of [Li(ec)ₙ][Ga(C₂F₅)₄]

Ethylene carbonate (1.084 g, 12.319 mmol) was added to [Li(dec)₂][Ga(C₂F₅)₄] (4.659 g, 5.89 mmol) and stirred for 1 h. All volatile compounds were removed in high vacuum to obtain [Li(ec)*ₙ*][Ga(C₂F₅)₄] as a yellowish liquid (3.662 g). From this oil slowly grew crystals suitable for XRD
¹H NMR ([D₃]acetonitrile, 298 K): δ= 4.48 ppm (s, 2H; CH₂);
⁷Li{¹H} NMR ([D₃]acetonitrile, 298 K): δ= -2.1 ppm (s; Li);
¹³C{¹H} NMR ([D₃]acetonitrile, 298 K): δ= 159.3 (s; C), 64.8 ppm (s; CH₂);
¹³C{¹⁹F} NMR ([D₃]acetonitrile, 298 K): δ= 120.8 ppm (s; CF₃);
¹⁹F NMR ([D₃]acetonitrile, 298 K): δ= -122.8 (s (broad), 8F; CF₂), -84.5 ppm (s, ¹*J*(F,C)=282 Hz, 12F; CF₃);
IR (ATR): ν̃ = 1813 (w), 1786 (w), 1770 (m), 1730 (m), 1486 (w), 1430 (w), 1410 (w),1311 (m), 1173 (s), 1083 (s), 1030 (m), 933 (m), 906 (m), 783 (w), 730 cm⁻¹(m);
MS (ESI, neg.) *{m*/*z* (%) [assignment]}: 345.0 (5) [Ga(C₂F₅)₂F₂]⁻, 445.1 (16) [Ga(C₂F₅)₃F]⁻, 545.1 (100) [Ga(C₂F₅)₄]⁻.

### Reaction of [Ga(C₂F₅)₃(dmap)] with LiC₂F₅

A solution of *n*-butyllithium (8.5 mL, 14 mmol, 1.6 M in *n*-hexane) in diethyl ether (150 mL) was degassed at -80 °C. Pentafluoroethane (727 mbar, 18 mmol) was condensed onto the solution. After stirring for 30min at -80 °C a solution of [Ga(C₂F₅)₃(dmap)] (2.00 g, 3.65 mmol) in diethyl ether (12 mL) was added to the in situ generated pentafluoroethyllithium at -80 °C. The mixture was allowed to reach room temperature within 6h.

Aqueous lithium hydroxide solution (1M, 100 mL) was added to the crude product suspension and stirred for one day. The organic layer was separated and the aqueous layer extracted with diethyl ether (3 x 50 mL). The combined organic phases were dried over magnesium sulfate, tetraphenylphosphonium chloride (2.17 g, 5.8 mmol) was added and the mixture stirred for 1 day.

Aqueous hydrochloric acid (1 M, 50 mL) was added to the suspension and the aqueous layer was separated. The organic layer was washed with aqueous hydrochloric acid (1 M, 3 x 50 mL). The combined organic layers were dried over magnesium sulfate and all volatile compounds were removed in high vacuum to obtain tetraphenylphosphonium tetrakis(pentafluoroethyl)gallate, [PPh₄][Ga(C₂F₅)₄], as an off-white solid (9.332 g, 10.56 mmol, 61 %).
¹H NMR ([D]chloroform, 298 K): δ= 7.9 (m, 4H; para-CH), 7.8 (m, 8H; meta-CH), 7.7 ppm (m, 8H; ortho-CH);
¹⁹F NMR ([D]chloroform, 298 K): δ= -122.3 (s, 8F; CF₂), -83.9 ppm (s, ¹*J*(F,C)=284 Hz, 12F; CF₃);
MS (ESI, pos.) *{m*/*z* (%) [assignment]}: 179.3 (25), 339.2 (100) [PPh₄]⁺, 413.2 (18);
MS (ESI, neg.) *{m*/*z* (%) [assignment]}: 146.6 (7) [GaF₄]⁻, 244.7 (72) [Ga(C₂F₅)F₃]⁻, 344.7 (100) [Ga(C₂F₅)₂F₂]⁻, 444.6 (60) [Ga(C₂F₅)₃F]⁻, 544.6 (19) [Ga(C₂F₅)₄]⁻.

### Reaction of [Ga(C₂F₅)₃(dmap)] with [PPh₄]Cl

Tetraphenylphosphonium chloride (0.56, 1.50 mmol) was added to a solution of [Ga(C₂F₅)₃(dmap)] (0.53 g, 0.97 mmol) in diethyl ether (10 mL) and the suspension was stirred for 2 days. Aqueous hydrochloric acid (1 M, 15 mL) was added to the suspension and the aqueous layer was separated. The organic layer was washed with aqueous hydrochloric acid (1 M, 2 x 15 mL). The combined organic layers were dried over magnesium sulfate and all volatile compounds were removed in high vacuum to obtain tetraphenylphosphonium chlorotris(pentafluoroethyl)gallate, [PPh₄][Ga(C₂F₅)₃Cl], as a colorless solid.
¹H NMR ([D]chloroform, 298 K): δ= 7.9 (m, 4H; para-CH), 7.8 (m, 8H; meta-CH), 7.7 ppm (m, 8H; ortho-CH);
¹⁹F NMR ([D]chloroform, 298 K): δ= -124.9 (s, ¹*J*(F,C)=286 Hz, 6F; CF₂), -83.2 ppm (s, ¹*J*(F,C)=285 Hz, 9F; CF₃);
MS (ESI, pos.) *{m*/*z* (%) [assignment]}: 339.2 (100) [PPh₄]⁻;
MS (ESI, neg.) *{m*/*z* (%) [assignment]}: 187.1 (24), 261.0 (20), 360.9 (67) [Ga(C₂F₅)₂ClF]⁻, 460.7 (100) [Ga(C₂F₅)₃Cl]⁻.

### Reaction of [Ga(C₂F₅)₃(OEt₂)] with LiC₂F₅

A solution of *n*-butyllithium (11 mL, 18 mmol, 1.6 M in *n*-hexane) in diethyl ether (150 mL) was degassed at -80 °C. Pentafluoroethane (905 mbar, 23 mmol) was condensed onto the solution. After stirring for 30min at -80 °C a solution of [Ga(C₂F₅)₃(OEt₂)] (2.57 g, 5.14 mmol) in diethyl ether (8 mL) was added to the in situ generated pentafluoroethyllithium at -80 °C. The mixture was allowed to reach room temperature within 6 h.

Aqueous lithium hydroxide solution (1M, 100 mL) was added to the crude product suspension and stirred for one day. The organic layer was separated and the aqueous layer extracted with diethyl ether (3 x 50 mL). The combined organic phases were dried over magnesium sulfate, tetraphenylphosphonium chloride (2.826 g, 7.56 mmol) was added and stirred for 1 day. The precipitate was filtered off and all volatile components of the filtrate were removed in high vacuum. Tetraphenylphosphonium tetrakis(pentafluoroethyl)gallate, [PPh₄][Ga(C₂F₅)₄], was obtained as a white solid (2.37 g, 2.68 mmol, 52 %).
¹H NMR ([D]chloroform, 298 K): δ= 7.9 (m, 4H; para-CH), 7.8 (m, 8H; meta-CH), 7.7 ppm (m, 8H; ortho-CH);
¹⁹F NMR ([D]chloroform, 298 K): δ= -122.3 (s, 8F; CF₂), -83.9 ppm (s, ¹*J*(F,C)=284 Hz, 12F; CF₃);
MS (ESI, pos.) *{m*/*z* (%) [assignment]}: 339.2 (100) [PPh₄]⁺;
MS (ESI, neg.) *{m*/*z* (%) [assignment]}: 245.0 (6) [Ga(C₂F₅)F₃]⁻, 344.9 (25) [Ga(C₂F₅)₂F₂]⁻, 444.8 (68) [Ga(C₂F₅)₃F]⁻, 544.7 (100) [Ga(C₂F₅)₄]⁻.

### Reaction of [Ga(C₂F₅)₃(OEt₂)] with [PPh₄]Cl

A solution of [Ga(C₂F₅)₃(OEt₂)] (0.52 g, 1.39 mmol) in diethyl ether (20 mL) was added to a suspension of tetraphenylphosphonium chloride (0.44, 0.88 mmol) in diethyl ether (10 mL) a solution of [Ga(C₂F₅)₃(OEt₂)] (0.52 g, 1.39 mmol) in diethyl ether (20 mL) was added and the suspension was stirred for 1 day. The precipitate was filtered off and all volatile components of the filtrate were removed in high vacuum to obtain tetraphenylphosphonium chlorotris(pentafluoroethyl)gallate, [PPh₄][Ga(C₂F₅)₃Cl], as a white solid (0.551 g, 0.689 mmol, 78 %).
¹H NMR ([D]chloroform, 298 K): δ= 7.9 (m, 4H; para-CH), 7.8 (m, 8H; meta-CH), 7.7 ppm (m, 8H; ortho-CH);
¹⁹F NMR ([D]chloroform, 298 K): δ= -124.9 (s, ¹*J*(F,C)=286 Hz, 6F; CF₂), -83.2 ppm (s, ¹*J*(F,C)=285 Hz, 9F; CF₃);
MS (ESI, pos.) *{m*/*z* (%) [assignment]}: 339.2 (100) [PPh₄]⁻;
MS (ESI, neg.) *{m*/*z* (%) [assignment]}: 187.0 (34), 278.9 (32) [Ga(C₂F₅)ClF₂]⁻, 362.9 (26) [Ga(C₂F₅)₂ClF]⁻, 378.8 (40) [Ga(C₂F5)₂Cl₂]⁻, 460.8 (100) [Ga(C₂F₅)₃Cl]⁻, 464.6 (20).

### Reaction of [Ga(C₂F₅)₃(OEt₂)] with [PPh₄]Br

To a suspension of tetraphenylphosphonium bromine (1.647 g, 3.95 mmol) in diethyl ether (20 mL) a solution of [Ga(C₂F₅)₃(OEt₂)] (0.95 g, 1.90 mmol) in diethyl ether (15 mL) was added and the suspension was stirred for 1 day. The precipitate was filtered off and all volatile components of the filtrate were removed in high vacuum to obtain tetraphenylphosphonium bromotris(pentafluoroethyl)gallate, [PPh₄][Ga(C₂F₅)₃Br], as a white solid (1.474 g, 1.72 mmol, 87 %).
¹H NMR ([D]chloroform, 298 K): δ= 7.9 (m, 4H; para-CH), 7.8 (m, 8H; meta-CH), 7.7 ppm (m, 8H; ortho-CH);
¹⁹F NMR ([D]chloroform, 298 K): δ= -124.2 (s, ¹*J*(F,C)=290 Hz, 6F; CF₂), -82.8 ppm (s, ¹*J*(F,C)=285 Hz, 9F; CF₃);
MS (ESI, pos.) *{m*/*z* (%) [assignment]}: 339.2 (100) [PPh₄]⁺, 379.3 (4);
MS (ESI, neg.) *{m*/*z* (%) [assignment]}: 307.1 (41) [Ga(C₂F₅)BrF₂]⁻, 343 (6), 361 (14), 406.7 (100) [Ga(C₂F₅)₂BrF]⁻, 442.8 (2) [Ga(C₂F₅)₃(OH)]⁻, 462.7 (4) [Ga(C₂F₅)₃Cl]⁻, 506.6 (18) [Ga(C₂F₅)₃Br]⁻.

### Synthesis of [HDMAP] [Ga(C₂F₅)₃F]

Anhydrous hydrogen fluoride (5 mL) was condensed onto [Ga(C₂F₅)₃(dmap)] (0.542 g, 0.987 mmol) in an FEP tube. After stirring for 40 min all volatile compounds were removed in high vacuum and [HDMAP][Ga(C₂F₅)₃F] was obtained as a colorless liquid (0.562 g, 0.987 mmol, 100 %). Crystals suitable for XRD were grown by in situ crystallization in a capillary.
¹H NMR ([D]chloroform, 298 K): δ= 12.87 (broad, 1H, HN), 8.06 (m, ³*J*(H,H)=7 Hz, 2H; Ar-H), 6.76 (d, ³*J*(H,H)=7 Hz, 2H; Ar-H), 3.27 ppm (s, ¹*J*(C,H)=140 Hz, 6H; CH₃);
¹³C{¹H} NMR ([D]chloroform, 298 K): δ= 157.4 (s; arom. C), 138.9 (s; arom. C), 106.9 (s; arom. C), 40.1 ppm (s; CH₃);
¹³C{¹⁹F} NMR ([D]chloroform, 298 K): δ= 125.1 (s (broad); CF₂), 120.8 ppm (s; CF₃);
¹⁹F NMR ([D]chloroform, 298 K): δ= -217.6 (s (broad), IF, GaF), -126.3 (s, ¹*J*(F,C)=283 Hz, 6F; CF₂), -84.0 ppm (s, ¹*J*(F,C)=282 Hz, 9F; CF₃);
IR (ATR): *ν̃* = 3238 (w), 3104 (w), 2985 (w), 2879 (w), 1650 (m), 1605 (w), 1566 (m), 1446 (w), 1314 (m), 1180 (s), 1102 (s), 1037 (m), 1001 (m), 937 (m), 804 (m), 734 (m), 552 (m), 506 cm⁻¹(w).
MS (ESI, pos.) *{m*/*z* (%) [assignment]}: 123.0 (100) [HDMAP]⁺;
MS (ESI, neg.) *{m*/*z* (%) [assignment]}: 244.8 (8) [Ga(C₂F₅)F₃]⁻, 344.9 (32) [Ga(C₂F₅)₂F₂]⁻, 444.8 (100) [Ga(C₂F₅)₃F]⁻;
accurate mass (ESI): calcd. for C₆F₁₆Ga⁻ 444.90058; found 444.9010;
elemental analysis calcd. (%) for C₁₃H₁₁F₁₆GaN₂: C 27.44, H 1.95, Ga 12.25; found: C 28.62, H 2.11, Ga 11.97.

### Synthesis of [Mg(dme)₃][Ga(C₂F₅)₄]₂.

A solution of *n*-butyllithium (112mL, 179 mmol, 1.6M in *n*-hexane) in diethyl ether (300 mL) was degassed at -80 °C. Pentafluoroethane (1695 mbar, 211 mmol) was condensed onto the solution. After stirring for 30 min at -80 °C a solution of gallium trichloride (4.380 g, 24.875 mmol) and DMAP (3.102 g, 25.391 mmol) in dichloromethane (28 mL) was added to the in situ generated pentafluoroethyllithium at -80 °C. The mixture was allowed to reach room temperature overnight.

Aqueous hydrochloric acid (1 M, 100 mL) was added to the crude product suspension and the aqueous layer was separated. The organic layer was washed with aqueous hydrochloric acid (1 M, 100 mL). Magnesium hydroxide (5.9 g, 102 mmol) and water (100 mL) were added to the organic layer and the resulting suspension was stirred for 18 hours. The precipitate was filtered off.

The organic layer was separated, washed with water (2 x 40 mL) and dried over magnesium sulfate. All volatile compounds were removed in high vacuum to obtain a brown liquid (11.557 g). Water (60 mL) was added to the brown liquid and a brown oil separated. This mixture was filtered over celite and the filter cake was washed with water (190 mL). Again diethyl ether (250 mL) and magnesium hydroxide (3.0 g, 53 mmol) were added and the mixture stirred for 18 hours. The precipitate was filtered off, the organic layer was separated and dried over magnesium sulfate. All volatile compounds were removed in high vacuum to obtain a colorless solid.

The solid was dissolved in ethylene glycol dimethyl ether (150 mL). At 130 °C, the solution was distilled off and all volatile compounds of the residue were removed in high vacuum. [Mg(dme)₃][Ga(C₂F₅)₄]₂, was obtained as a colorless solid (7.954 g, 5.546 mmol, 45 %).
¹H NMR ([D₃]acetonitrile, 298 K): δ= 3.49 (s, 6H; CH₂), 3.33 ppm (s, 9H; CH₃);
¹³C{¹H} NMR ([D₃]acetonitrile, 298 K): δ= 71.1 (s; CH₂), 58.1 ppm (s; CH₃);
¹³C{¹⁹F} NMR ([D₃]acetonitrile, 298 K): δ= 121.1 ppm (s; CF₃);
¹⁹F NMR ([D₃]acetonitrile, 298 K): δ= -122.3 (s, 8F; CF₂), -83.9 ppm (s, ¹*J*(F,C)=280 Hz, 12F; CF₃);
^{7l}Ga NMR ([D₃]acetonitrile, 298 K): δ= 180.1 ppm (m, ¹*J*(Ga,F)=115 Hz; Ga);
IR (ATR): *ν̃* = 2968 (w), 1485 (w), 1455 (w), 1313 (s), 1296 (m), 1179 (m), 1087 (s), 1021 (w), 936 (s), 866 (s), 828 (m), 733 (s), 600 (w), 587 (w), 532 (s), 433 cm⁻¹ (m);
MS (ESI, neg.) {*m*/*z* (%) [assignment]}: 164.9 (69), 239.0 (37), 297.0 (11), 344.9 (7) [Ga(C₂F₅)₂F₂]⁻, 444.9 (23) [Ga(C₂F₅)₃F]⁻, 544.9 (100) [Ga(C₂F₅)₄]⁻;
elemental analysis calcd. (%) for C₂₈H₃₀F₄₀Ga₂MgO₆: C 24.26, H 2.18, Ga 10.06, Mg 1.75; found: C 24.21, H 2.22, Ga 10.09, Mg 1.72.

### Synthesis of [Li(OEt₂)][Ga(C₂F₅)₄]

A solution of *n*-butyllithium (21 mL, 33.6 mmol, 1.6 M in *n*-hexane) in diethyl ether (250 mL) was degassed at -80 °C. Pentafluoroethane (1627 mbar, 41 mmol) was condensed onto the solution. After stirring for 30min at -80 °C a solution of [Ga(C₂F₅)₃(OEt₂)] (3.904 g, 7.804 mmol) in diethyl ether (18 mL) was added to the in situ generated pentafluoroethyllithium at -80 °C and the mixture was allowed to reach room temperature within 6 h. Anhydrous lithium hydroxide (6.125 g, 255.0 mmol) was added to the crude product suspension and stirred for 4 d. The precipitate was filtered off and the filter cake was washed with diethyl ether (100 mL). All volatile components of the filtrate were removed in high vacuum to obtain [Li(OEt₂)][Ga(C₂F₅)₄] (2.712 g, 4.326 mmol, 56 %) as a light brown oil. Crystals suitable for XRD were slowly grown from this oil at 4 °C.
¹H NMR ([D₃]acetonitrile, 298 K): δ= 3.44 (q, ³*J*(H,H)=3 Hz, 4H; CH₂), 1.15 ppm (t, ³*J*(H,H)=3 Hz, 6H; CH₃);
¹⁹F NMR ([D₃]acetonitrile, 298 K): δ= -122.8 (s (broad), 8F; CF₂), -84.5 ppm (s, 12F; CF₃); IR (ATR): *ν̃* = 1438 (w), 1296 (m), 1186 (s), 1105 (m), 1058 (w), 977 (m), 929 (m), 731 (m), 587 (w), 530 (w), 437 cm⁻¹(s).
MS (ESI, neg.) *{m*/*z* (%) [assignment]}: 245.0 (8) [Ga(C₂F₅)F₃]⁻, 345.0 (54) [Ga(C₂F₅)₂F₂]⁻, 444.9 (100) [Ga(C₂F₅)₃F]⁻, 544.7 (24) [Ga(C₂F₅)₄]⁻.
elemental analysis calcd. (%) for C₁₂H₁₀F₂₀GaLiO: C 22.99, H 1.61, Ga 11.12; found: C 22.89, H 1.63, Ga 11.05.

### Synthesis of [H(OEt₂)₂][Ga(C₂F₅)₃Cl]

Anhydrous hydrogen chlorine (1030 mbar, 26 mmol) was condensed onto a solution of [Ga(C₂F₅)₃(OEt₂)] (3.441 g, 6.869 mmol) in diethyl ether (120 mL) at -80 °C. The mixture was allowed to reach room temperature within 15 h. All volatile compounds were removed in high vacuum and [H(OEt₂)₂][Ga(C₂F₅)₃Cl] was obtained as a colorless liquid (4.161 g, 6.805 mmol, 99 %).
¹H NMR ([D₆]acetone; external lock, 298 K): δ= 12.06 (broad, 1H, H), 3.06 (q, ³*J*(H,H)=7 Hz, 8H; CH₂), 0.38 ppm (t, ³*J*(H,H)=7 Hz, 12H; CH₃);
¹³C{¹H} NMR ([D₆]acetone; external lock, 298 K): δ= 120.1 (q, t, ¹*J*(C,F)=283 Hz, ²*J*(C,F)=29 Hz; CF₃), 68.4 (s; CH₂), 11.4 ppm (s; CH₃);
¹⁹F NMR ([D₆]acetone; external lock, 298 K): δ= -126.3 (s, 6F; CF₂), -85.2 ppm (s, 9F; CF₃); MS (ESI, neg.) *{m*/*z* (%) [assignment]}: 222.9 (6), 242.8 (14) [Ga(C₂F₅)F₂(OH)]⁻, 260.8 (63)
[Ga(C₂F₅)ClF₂]⁻, 342.8 (74) [Ga(C₂F₅)₂F(OH)]⁻, 360.8 (100) [Ga(C₂F₅)₂ClF]⁻, 442.8 (64) [Ga(C₂F₅)₃(OH)]⁻, 462.7 (59) [Ga(C₂F₅)₃Cl]⁻, 870.6 (6) [(F₅C₂)₃Ga(*µ*-OH)Ga(C₂F5)₃]⁻;
elemental analysis calcd. (%) for C₄H₂ClF₅GaO₂: C 27.50, H 3.46, Ga 11.40; found: C 24.99, H 3.01, Ga 10.29.

### Synthesis of [PPh₄] [Ga(CF=CF₂)₄]

A solution of *n*-butyllithium (83 mL, 132 mmol, 1.6 M in hexane) in diethyl ether (400 mL) was degassed at -80 °C. 1,1,1,2-Tetrafluoroethane (2645 mbar, 66 mmol) was condensed onto the solution. After stirring for 10 min at -80 °C the solution was warmed to -50 °C and stirred until a slight brown color was observed. The solution was cooled to -80 °C and a solution of GaCl₃ (2.33 g, 13.25 mmol) in diethyl ether (20 mL) was added to the *in situ* generated trifluorovinyllithium at -80 °C. The reaction mixture was allowed to reach room temperature within 18 h. Subsequently the obtained suspension was filtered and the solvent was removed under reduced pressure. The residue was dissolved in diethyl ether (100 mL) and tetraphenylphosphonium chloride (6.18 g, 8.43 mmol) was added. After stirring at room temperature for 19 h the suspension was filtered and the solvent was removed under reduced pressure. The residue was dissolved in diethyl ether (15 mL) and through diffusion of *n-*pentane into the solution [PPh₄][Ga(CF=CF₂)₄] was obtained as a brown, crystalline solid (6.18 g, 8.43 mmol, 64 %). Crystals suitable for XRD as well as a sample for elemental analysis were obtained from chloroform at -28 °C.
M.p.: 83 °C
¹H NMR ([D₃]acetonitrile, 298 K): δ= 7.95 (m, 1H, para-CH), 7.77 (m, 2H, meta-CH), 7.72 ppm (dd, ²*J*(H,P)=13 Hz, ³*J*(H,H)=8 Hz, 2H, ortho-CH);
¹³C{¹H} NMR ([D₃]acetonitrile, 298 K): δ= 136.4 (d, ⁴*J*(C,P)=3 Hz, para-CH), 135.7 (d, ³*J*(C,P)=10 Hz, meta-CH), 131.3 (d, ²*J*(C,P)=13 Hz, ortho-CH), 118.9 ppm (d,
¹*J*(C,P)=90 Hz, ipso-C);
¹⁹F,¹³C-HMQC NMR ([D₃]acetonitrile, 298 K): δ= -126.4/162.2 ppm (s, Z-F/CF₂).
¹⁹F NMR ([D₃]acetonitrile, 298 K): δ= -195.4 (m (broad), IF, *gem.-F),* -125.1 (dd, ³*J*(F,F)*ₜᵣₐₙₛ*=110 Hz, ²*J*(F,F)*_{gem.}*=86Hz), IF, Z-F), -92.7 ppm (dd, ²*J*(F,F)*_{gem.}*=85Hz, ³*J*(F,F)*_{cis}*=28Hz), IF, *E*-F);
⁷¹Ga NMR ([D₃]acetonitrile, 298 K): δ= 229.5 ppm (m (broad), Ga);
IR (ATR): v = 1700 (s), 1587 (vw), 1485 (w), 1438 (m), 1397 (vw), 1341 (vw), 1316 (vw), 1276 (w), 1248 (s), 1188 (vw), 1165 (vw), 1147 (s), 1108 (s), 1080 (s), 990 (w), 931 (s), 752 (m), 723 (s), 689 (s), 638 (w), 555 (w), 525 (vs), 448 cm⁻¹ (w);
MS (ESI, pos.) *{m*/*z* (%) [assignment]}: 339.2 (100) [PPh₄]⁺;
MS (ESI, neg.) *{m*/*z* (%) [assignment]}: 330.9 (22) [Ga(C₂F₃)₃OH]⁻, 392.8 (100)
[Ga(C₂F₃)₄]⁻;
accurate mass (ESI, negativ): calc.: 392.90697 *m*/*z,* found: 392.9059 *m*/*z;*
elemental analysis calcd. (%) for C₃₂H₂₀F₁₂GaP: C 52.42, H 2.75, F 31.09, P 4.22, Ga 9.51; found: C 52.33, H 2.93, F 30.89, P 4.37, Ga 9.47.

### Synthesis of [PPh₄] [Ga(E-CF=C(F)CF₃)₄]

A solution of *n*-butyllithium (10.4 mL, 16.7 mmol, 1.6 M in hexane) in diethyl ether (150 mL) was degassed at -80 °C. (*Z*)-1,2,3,3,3-Pentafluoroprop-1-ene (700 mbar, 18 mmol) was condensed onto the solution. After stirring the solution for 15 min at -80 °C a solution of GaCl₃ (0.578 g, 3.28 mmol) in diethyl ether (10 mL) was added to the *in situ* generated E-pentafluoropropenyllithium. The reaction mixture was allowed to reach room temperature within 18 h. Subsequently the obtained suspension was filtered and the solvent was removed under reduced pressure. The residue was dissolved in diethyl ether (200 mL) and tetraphenylphosphonium chloride (1.80 g, 4.80 mmol) was added. After stirring for 1 d at room temperature the suspension was filtered and the solvent removed under reduced pressure. The residue was recrystallized in dichloromethane at -28 °C. [PPh₄][Ga(*E-*CF=C(F)CF₃)₄] was obtained as slightly brown crystals (0.590 g, 0.632 mmol, 19 %).
M.p.: 139 °C
¹H NMR ([D₃]acetonitrile, 298 K): δ= 7.95 (m, 1H, para-CH), 7.77 (m, 2H, meta-CH), 7.72 ppm (dd, ²*J*(H,P)=13 Hz, ³*J*(H,H)=8 Hz, 2H, ortho-CH);
¹³C{¹H} NMR ([D₃]acetonitrile, 298 K): δ= 136.4 (d, ⁴*J*(C,P)=3 Hz, para-CH), 135.7 (d, ³*J*(C,P)=10 Hz, meta-CH), 131.3 (d, ²*J*(C,P)=13 Hz, ortho-CH), 121.4 (ddd, ¹*J*(C,F)=269 Hz, ²*J*(C,F)=38 Hz, ³*J*(C,F)=13 Hz, CF₃), 118.9 ppm (d, ¹*J*(C,P)=90 Hz, ipso-C); ¹⁹F,¹³C-HMQC NMR ([D₃]acetonitrile, 298 K): δ= -150.2/143.6 ppm (s, C(F)CF₃/C(F)CF₃). ¹⁹F NMR ([D₃]acetonitrile, 298 K): δ= -149.3 (q (broad), ³*J*(F,F)=14 Hz, IF, E-F), -136.2 (s (broad), IF, *gem.-F),* -69.5 ppm (dd, ³*J*(F,F)=3 Hz, ⁴*J*(F,F)ₜᵣₐₙₛ=15 Hz), 3F, CF₃);
⁷¹Ga NMR ([D₃]acetonitrile, 298 K): δ= 214.8 ppm (m (broad), Ga);
IR (ATR): v = 1661 (w), 1590 (vw), 1487 (vw), 1442 (w), 1359 (m), 1315 (vw), 1300 (vw), 1183 (s), 1127 (m), 1109 (vs), 1057 (vs), 997 (w), 903 (s), 749 (s), 726 (s), 687 (m), 589 (w), 525 (vs), 452 (vw), 436 (vw), 423 (vw), 395 cm⁻¹ (w);
MS (ESI, pos.) *{m*/*z* (%) [assignment]}: 339.2 (100) [PPh₄]⁺;
MS (ESI, neg.) *{m*/*z* (%) [assignment]}: 593.0 (100) [Ga(C₃F₅)₄]⁻;
accurate mass (ESI, negativ): calc.: 592.89419 *m*/*z,* found: 5928945 *m*/*z;*
elemental analysis calcd. (%) for C₃₆H₂₀F₂₀GaP: C 46.33, H 2.16, F 40.72, P 3.32, Ga 7.47; found: 45.89, H 2.49, F 41.50, P 3.06, Ga 6.72.

### Synthesis of [PPh₄][Ga(C≡C-CF₃)₄]

A solution of *n*-butyllithium (10.8 mL, 17.2 mmol, 1.6 M in hexane) in diethyl ether (30 mL) was degassed at -80 °C. 2,3,3,3-Tetrafluoropropene (346 mbar, 9 mmol) was condensed onto the solution. After stirring for 30 min at -80 °C the solution was allowed to warm to -50 °C and the cooling bath was replaced with a -35 °C cooling bath. The solution was stirred for another 30 min after which it was cooled to -80 °C. A solution of GaCl₃ (0.274 g, 1.56 mmol) in diethyl ether (6 mL) was added to the *in situ* generated 3,3,3-trifluoropropinyllithium at -80 °C. The reaction mixture was allowed to reach room temperature within 24 h. Subsequently tetraphenylphosphonium chloride (0.67 g, 1.79 mmol) was added to the obtained suspension. After stirring at room temperature for 20 h the suspension was filtered and the solvent was removed under reduced pressure. [PPh₄][Ga(C≡C-CF₃)₄] was obtained as colorless needles (0.90 g, 1.15 mmol, 74 %). Crystals suitable for XRD were grown from dichloromethane at -28 °C.
M.p.: 110 °C (decomp.);
¹H NMR ([D]chloroform, 298 K): δ= 7.95 (m, 1H, para-CH), 7.77 (m, 2H, meta-CH),
7.72 ppm (dd, ²*J*(H,P)=13 Hz, ³*J*(H,H)=8 Hz, 2H, ortho-CH);
¹³C{¹H} NMR ([D]chloroform, 298 K): δ= 136.0 (d, ⁴*J*(C,P)=3 Hz, para-CH), 134.4 (d, ³*J*(C,P)=10 Hz, meta-CH), 130.9 (d, ²*J*(C,P)=13 Hz, ortho-CH), 117.6 (d, ¹*J*(C,P)=90 Hz, ipso-C), 113.1 ppm (q, ¹*J*(C,F)=256 Hz, CF₃);
¹⁹F NMR ([D]chloroform, 298 K): δ= -49.3 (s, CF₃);
MS (ESI, pos.) {*m*/*z* (%) [assignment]}: 339.2 (100) [PPh₄]⁺;
MS (ESI, neg.) {*m*/*z* (%) [assignment]}: 364.8 (24) [Ga(C₃F₃)₃OH]⁻, 382.8 (35)
[Ga(C₃F₃)₃Cl]⁻, 404.8 (57) [Ga(C₃F₃)₃(C₄H₉)]⁻, 440.7 (100) [Ga(C₃F₃)₄]⁻.

### Use of an inventive compound in a battery

In the following the use of an inventive compound ([Li(dec)₂] [Ga(C₂F₅)₄]) as a replacement for LiPF₆ in lithium-cell batteries is described:

### Electrolyte preparation

All electrolytes were prepared in an argon-filled glove box (H2O and O2 < 1 ppm, MBRAUN). Electrolyte salts (batch numbers 1-3) were dried at 60 °C under vacuum in the glovebox antechamber for at least 12 h. Electrolyte components ethylene carbonate (EC), diethyl carbonate (DEC), vinylene carbonate (VC) (all from Iolitec, 99%) and Lithium difluoro(oxalate) borate (LiDFOB, from abcr, 99%) were used as received. The electrolyte, 1 Mol kg-1 [Li(dec)₂] [Ga(C₂F₅)₄] in (EC:DEC (1:1, by wt.) + 2 wt.% of VC + 2 wt.% of LiDFOB), was formulated. 1 Mol kg-1 LiPF₆ in (EC:DMC (1:1, by wt.) + 2 wt.% of VC) ready-to-use electrolyte (from UBE) was used as reference electrolyte.

### Electrochemical investigations and cell setup

Electrochemical formation of LiNi_{0.6}Mn_{0.2}Co_{0.2}O₂ (NMC622)/graphite full cells was carried out under temperature control at 25 °C in a climate chamber (Binder) using CR2032 stainlesssteel coin cells. NMC622 electrodes (Ø13 mm, 2.0 mAh cm-2, 90 % active material content), and graphite electrodes (Ø13 mm, 2.2 mAh cm-2, 96 % active material content) were manufactured from Customcells Itzehoe. Freudenberg FS2192 (polymer nonwoven, 016 mm, 1 layer) was used as separator, and 80 µL of electrolyte was applied in the cell. The electrochemical formation process was performed on a battery tester BaSyTec CTS. In order to improve the wetting of electrodes and separator with the liquid electrolyte, NMC622/graphite full cells were polarized to 3.5 V and stored for 3.5 h under open circuit voltage conditions. Full cells were cycled in the voltage range from 3.0 to 4.2 V. The cycling test was performed with two formation cycles at a charge and discharge rate of C/10, followed by two formation cycles at C/5. The charging step included a constant voltage step at 4.2 V until the measured current had dropped below 0.05C.

### Results and discussion

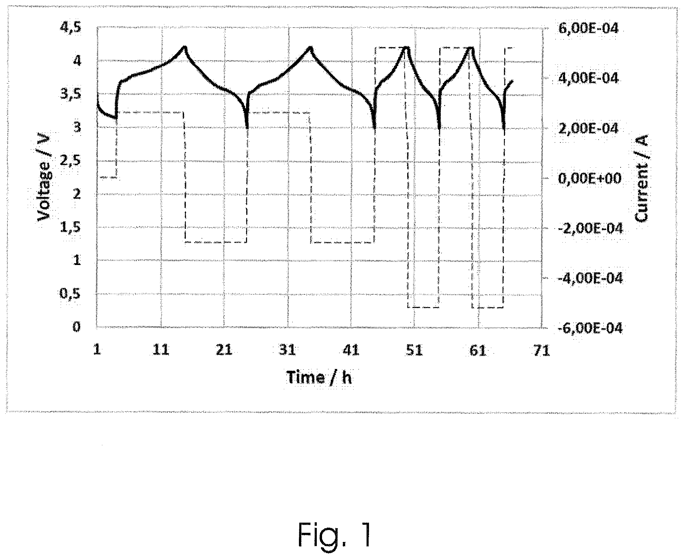

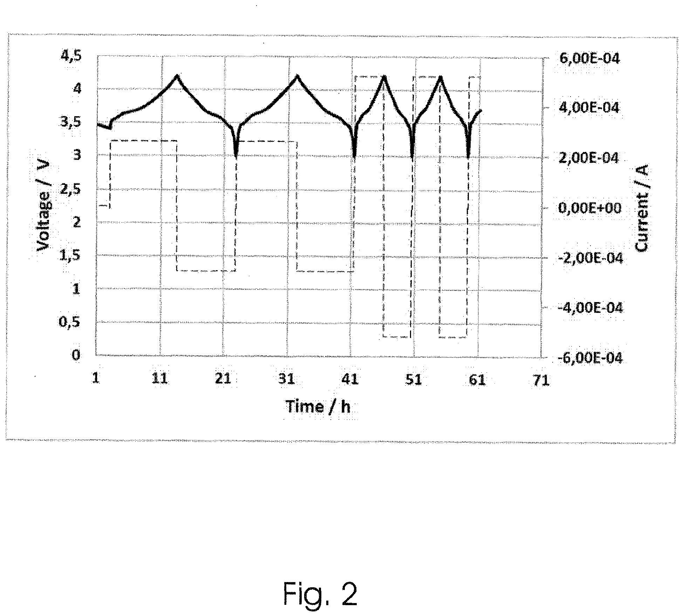

Fig. 1 and 2 show the voltage (dotted line) and current profiles of the initial cycles of the electrochemical formation process of NMC622/graphite full cells comprising either the reference electrolyte 1M LiPF₆ in EC:DMC (1:1, by wt.) + 2 wt.% VC (Fig. 2) or the new electrolyte 1M [Li(dec)₂] [Ga(C₂F₅)₄] in (EC:DEC (1:1, by wt.) + 2 wt.% of VC + 2 wt.% of LiDFOB) (Fig. 1) at 25 °C.

Both cells showed reversible Li+ ion (de-) intercalation during cycling. The Coulombic efficiency in the first cycle amounts to 88.6% and 82.4% for cells containing the reference electrolyte and new electrolyte, respectively. The high Coulombic efficiency and good reversibility displays that [Li(dec)₂][Ga(C₂F₅)₄] can be used as single electrolyte salt for the application in state-of-the-art lithium ion batteries. This is especially advantageous due to the instability of LiPF₆ above 70°C, whereas [Li(dec)₂][Ga(C₂F₅)₄] is much more stable.

The particular combinations of elements and features in the above detailed embodiments are exemplary only. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention's scope is defined in the following claims. Furthermore, reference signs used in the description and claims do not limit the scope of the invention as claimed.

## Claims

1. A gallium-containing compound comprising the moiety
GaR¹R²R³R⁴
whereby
R¹ is a fluoroalkyl, fluoroalkenyl and/or fluoroalkynyl moiety of the structure CₘHₙFₒ, whereby m > 1, n ≥ 0 and o > 0, whereby in one or more C-C bonds (if they are present) a -O-, -S-, -NH-, -CO-, -COO-, -OCO-, -OCO-O-, -SO₂-, -S-CO-, -CO-S- unit may be inserted in that way that O and/or S atoms are not directly bound to each other.
R² to R⁴ are independently from each other a moiety as defined for R¹, halogen, fluoroaryl, amines,aminocycloalkyl, N-heteroaryl, phosphanides, amide, phosphanes, alkyloxy, ethers, water or a moiety of the structure -R⁵-GaR⁶R⁷R⁸ whereby R⁵ is selected out of the group comprising halogen, O, alkyloxy, amine, phosphanide, R⁶ is defined same as R¹ and R⁷ and R⁸ are defined as a moiety as defined for R¹, halogen, fluoroaryl, amines, aminocycloalkyl, N-heteroaryl, phosphanides, amide, phosphanes, alkyloxy, ethers, water.

2. The compound according to claim 1, whereby m is ≤ 8.

3. The compound according to Claim 1 or 2, whereby o>n

4. The compound according to any of the claims 1 to 3, whereby at least one of R² and R³ are a moiety as defined for R¹

5. The compound according to any of the claims 1 to 4, whereby at least one of R² and R³ are identical with R¹.

6. The compound according to any of the claims 1 to 5, whereby the compound is uncharged and one of R² to R⁴ is selected from amine, aminocycloalkyl and N-heteroaryl

7. The compound according to any of the claims 1 to 5, whereby the compound is charged.

8. The compound according to claim 7, whereby the compound comprises one or more cations.

9. A compound according to any of the claims 7 to 8, whereby the compound comprises one or more cations selected from NO⁺, H⁺, oxonium cations, metal and organic cations.

10. The use of a compound according to any of the claims 1 to 9 for one or more of the following applications:
- Batteries
- ionic liquids,
- antitstatic agent,
- photopolymerization initiator
- photoacid generator an
- (Lewis-) acid catalyst,
- conductive salt in cyclovoltametry
- stabilizer of catalysts in polymerisations reactions

## Patentansprüche

1. Galliumhaltige Verbindung, aufweisend die Gruppe GaR¹R²R³R⁴, wobei
R¹ eine Fluoralkyl-, Fluoralkenyl- und/oder Fluoralkinylgruppe der Struktur CₘHₙFₒ ist, wobei m > 1, n ≥ 0 und o > 0 ist, wobei in einer oder mehreren C-C-Bindungen (falls vorhanden) eine -O-, -S-, -NH-, -CO-, - COO-, -OCO-, -OCO-O-, -SO₂-, -S-CO-, -CO-S- Einheit derart eingefügt sein kann, dass O- und/oder S-Atome nicht direkt aneinander gebunden sind,
R² bis R⁴ unabhängig voneinander eine Gruppe wie für R¹ definiert, Halogen, Fluoraryl, Amine, Aminocycloalkyl, N-Heteroaryl, Phosphanide, Amid, Phosphane, Alkyloxy, Ether, Wasser oder eine Gruppe der Struktur - R⁵-GaR⁶R⁷R⁸ sind, wobei R⁵ ausgewählt ist aus der Gruppe bestehend aus einem Halogen, O, Alkyloxy, Amin, Phosphanid, R⁶ wie für R¹ definiert ist und R⁷ und R⁸ definiert sind als eine Gruppe wie für R¹ definiert, Halogen, Fluoraryl, Amine, Aminocycloalkyl, N-Heteroaryl, Phosphanide, Amid, Phosphane, Alkyloxy, Ether, Wasser.

2. Verbindung nach Anspruch 1, wobei m ≤ 8 ist.

3. Verbindung nach Anspruch 1 oder 2, wobei o > n ist.

4. Verbindung nach einem der Ansprüche 1 bis 3, wobei mindestens eine der Komponenten R² und R³ ein Gruppe ist wie für R¹ definiert.

5. Verbindung nach einem der Ansprüche 1 bis 4, wobei mindestens eines von R² und R³ mit R¹ identisch ist.

6. Verbindung nach einem der Ansprüche 1 bis 5, wobei die Verbindung ungeladen ist und eine der Komponenten R² bis R⁴ ausgewählt ist aus Amin, Aminocycloalkyl und N-Heteroaryl.

7. Verbindung nach einem der Ansprüche 1 bis 5, wobei die Verbindung geladen ist.

8. Verbindung nach Anspruch 7, wobei die Verbindung ein oder mehrere Kationen enthält.

9. Verbindung nach Anspruch 7 oder 8, wobei die Verbindung ein oder mehrere Kationen enthält, die ausgewählt sind aus NO⁺, H⁺, Oxoniumkationen, Metall- und organischen Kationen.

10. Verwendung einer Verbindung nach einem der Ansprüche 1 bis 9 für eine oder mehrere der folgenden Anwendungen:
Batterien;
ionische Flüssigkeiten;
Antistatikmittel;
Photopolymerisationsinitiator;
Photosäuregenerator;
(Lewis-) Säurekatalysator;
leitfähiges Salz in der Cyclovoltametrie;
Stabilisator von Katalysatoren in Polymerisationsreaktionen.

## Revendications

1. Composé contenant du gallium comprenant le fragment
GaR¹R²R³R⁴
dans lequel
R¹ est un fragment fluoroalkyle, fluoroalcényle et/ou fluoroalcynyle de structure CₘHₙFₒ, dans lequel m > 1, n ≥ 0 et o > 0, dans lequel dans une ou plusieurs liaisons C-C (si présentes), une unité -O-, -S-, -NH-, -CO-, -COO-, -OCO-, -OCO-O-, -SO₂-, -S-CO-, -CO-S- peut être insérée de sorte que les atomes O et/ou S ne soient pas directement reliés entre eux,
R² à R⁴ sont indépendamment l'un de l'autre un fragment tel que défini pour R¹, halogène, fluoroaryle, amines, aminocycloalkyle, N-hétéroaryle, phosphanures, amide, phosphanes, alkyloxy, éthers, eau, ou un fragment de structure -R⁵-GaR⁶R⁷R⁸ dans lequel R⁵ est choisi parmi le groupe comprenant un halogène, O, alkyloxy, amine, phosphanure, R⁶ est défini de façon identique à R¹ et R⁷ et R⁸ sont définis en tant que fragment tel que défini pour R¹, halogène, fluoroaryle, amines, aminocycloalkyle, N-hétéroaryle, phosphanures, amide, phosphanes, alkyloxy, éthers, eau.

2. Composé selon la revendication 1, dans lequel m est ≤ 8.

3. Composé selon la revendication 1 ou la revendication 2, dans lequel o > n.

4. Composé selon l'une quelconque des revendications 1 à 3, dans lequel au moins un de R² et R³ est un fragment tel que défini pour R¹.

5. Composé selon l'une quelconque des revendications 1 à 4, dans lequel au moins un de R² et R³ est identique à R¹.

6. Composé selon l'une quelconque des revendications 1 à 5, dans lequel le composé est neutre et un de R² à R⁴ est choisi parmi amine, aminocycloalkyle et N-hétéroaryle.

7. Composé selon l'une quelconque des revendications 1 à 5, dans lequel le composé est chargé.

8. Composé selon la revendication 7, dans lequel le composé comprend un ou plusieurs cations.

9. Composé selon la revendication 7 ou la revendication 8, dans lequel le composé comprend un ou plusieurs cations sélectionnés parmi NO⁺, H⁺, cations oxonium, cations organiques et métalliques.

10. Composé selon l'une quelconque des revendications 1 à 9 pour une ou plusieurs des applications suivantes :
- batteries,
- liquides ioniques,
- agent antistatiques,
- initiateurs de photopolymérisation,
- photogénérateur d'acide,
- catalyseur acide de Lewis,
- sel conducteur en voltammétrie cyclique,
- un stabilisateur de catalyseurs de réactions de polymérisation.
